# FASCICULE DE BREVET EUROPEEN

(11) **EP 2 842 229 B1**
(45) Date de publication et mention de la délivrance du brevet: **05.05.2021**
(21) Numéro de dépôt: 13723864.8
(22) Date de dépôt: 24.04.2013
(51) Int. Cl.: H03K 19/003, H03K 19/177

(54) **DISPOSITIF LOGIQUE REPROGRAMMABLE RESISTANT AUX RAYONNEMENTS**
REPROGRAMMIERBARE LOGISCHE VORRICHTUNG MIT STRAHLENWIDERSTANDSFÄHIGKEIT
REPROGRAMMABLE LOGIC APPARATUS WITH RADIATION HARDENING

(30) Priorité: 27.04.2012 FR 1253926
(43) Date de publication de la demande: 04.03.2015
(73) Titulaire: Commissariat à l'Énergie Atomique et aux Énergies Alternatives, 75015 Paris (FR); Centre National de la Recherche Scientifique, 75794 Paris Cedex 16 (FR)
(72) Inventeur: PRENAT, Guillaume, F-38000 Grenoble (FR); GONCALVES, Olivier, F-92160 Antony (FR)
(74) Mandataire: Cabinet Beaumont
(86) Numéro de dépôt international: PCT/FR2013/050910
(87) Numéro de publication internationale: WO 2013/160615

(56) Documents cités:
- US-B1- 7 764 081
- YOANN GUILLEMENET ET AL: "A non-volatile run-time FPGA using thermally assisted switching MRAMS", FIELD PROGRAMMABLE LOGIC AND APPLICATIONS, 2008. FPL 2008. INTERNATIONAL CONFERENCE ON, IEEE, PISCATAWAY, NJ, USA, 8 septembre 2008 (2008-09-08), pages 421-426, XP031324389, ISBN: 978-1-4244-1960-9
- GRYNKEWICH G ET AL: "NONVOLATILE MAGNETORESISTIVE RANDOM-ACCESS MEMORY BASED ON MAGNETIC TUNNEL JUNCTIONS", MRS BULLETIN, PITTSBURGH, US, no. 11, 1 novembre 2004 (2004-11-01), pages 818-821, XP007901070,

## Description

### Domaine

La présente invention concerne un dispositif logique reprogrammable, et un procédé pour rafraîchir un tel dispositif.

### Arrière-plan

Les dispositifs logiques reprogrammables, comme des FPGA (réseaux de portes programmables sur site), sont des dispositifs qui sont configurables pour réaliser une certaine fonction logique. De tels dispositifs comprennent en général des millions de cellules de mémoire statique à accès aléatoire (SRAM), chacune mémorisant des données de configuration pour configurer la fonction logique à mettre en oeuvre.

Les rayonnements, par exemple sous la forme de particules cosmiques, peuvent provoquer des erreurs dans les dispositifs électroniques, et sont particulièrement problématiques dans le cas de dispositifs logiques reprogrammables. En effet, les rayonnements peuvent provoquer des erreurs, non seulement dans les données qui sont en cours de traitement, mais aussi dans les données de configuration, ce qui provoque un changement de la fonction logique mise en oeuvre par le circuit

Le document de YOANN GUILLEMENET ET AL: "A non-volatile run-time FPGA using thermally assisted switching MRAMS",FIELD PROGRAMMABLE LOGIC AND APPLICATIONS, 2008. FPL 2008. INTERNATIONAL CONFERENCE ON, IEEE, PISCATAWAY, NJ, USA, publié le 8 septembre 2008 (2008-09-08), divulgue une mémoire magnétorésistive MRAM implémentée sur FPGA pour reconfiguration rapide de pavés logiques, la MRAM présentant une commutation améliorée lors de l'écriture afin de réduire la consommation totale de courant.

La publication de brevet américain US7764081 propose une solution pour protéger un dispositif logique reprogrammable contre des erreurs dues à des dérangements à évènement unique (SEU). Selon cette solution, les cellules de SRAM qui mémorisent les données de configuration dans le dispositif logique reprogrammable sont remplacées par des cellules de DRAM (mémoire dynamique à accès aléatoire), qui sont rafraîchies périodiquement à partir d'une mémoire PROM (mémoire programmable à lecture seulement).

Cependant, un problème avec la solution proposée par la publication de brevet US7764081 est que cette solution est relativement complexe et consommatrice d'énergie. Il y a donc un besoin dans la technique d'une solution simple et à faible consommation d'énergie pour protéger un dispositif de logique reprogrammable contre des erreurs provoquées par des rayonnements.

### Résumé

Un objet de modes de réalisation de la présente invention est de résoudre au moins partiellement un ou plusieurs problèmes de l'art antérieur.

Selon un aspect, on prévoit un dispositif logique reprogrammable selon la revendication indépendante 1.

Selon un mode de réalisation, chacune desdites une ou plusieurs cellules de mémoire volatile comprend une capacité pour mémoriser un état de tension représentatif de la donnée de configuration.

Selon un autre mode de réalisation, chacune des cellules de mémoire volatile comprend un transistor de sélection, et chacun des premier et deuxième éléments à commutation de résistance est couplé en série avec un autre transistor de sélection.

Selon un autre mode de réalisation, un bit de données de rafraîchissement mémorisé par chacune des cellules de mémoire non volatile est déterminé par les résistances relatives des premier et deuxième éléments à commutation de résistance.

Selon un autre mode de réalisation, les données de configuration contrôlent un ou plusieurs des éléments suivants : les valeurs de données se trouvant dans une table de correspondance du bloc logique ; la sélection de lignes d'entrée du bloc logique ; et la sélection de lignes de sortie du bloc logique.

Selon un autre mode de réalisation, la mémoire comprend en outre un module d'activation pour activer sélectivement la mémoire.

Selon un autre mode de réalisation, le circuit de lecture-écriture comprend une bascule comprenant des premier et deuxième transistors, une première borne du premier élément à commutation de résistance de chacune de la pluralité de cellules de mémoire non volatile étant couplée au premier transistor, et une première borne du deuxième élément à commutation de résistance de chacune de la pluralité de cellules de mémoire non volatile étant couplée au deuxième transistor.

Selon un autre mode de réalisation, le dispositif comprend un circuit de commande, et le premier transistor est couplé entre un premier noeud de mémorisation et une première tension d'alimentation, le deuxième transistor est couplé entre un deuxième noeud de mémorisation et la première tension d'alimentation, une borne de commande du premier transistor étant couplée au deuxième noeud de mémorisation, et une borne de commande du deuxième transistor étant couplée au premier noeud de mémorisation, et le circuit de commande est adapté à appliquer, pendant une phase de programmation du premier élément à commutation de résistance, une deuxième tension d'alimentation au deuxième noeud de mémorisation pour activer le premier transistor, puis à appliquer la deuxième tension d'alimentation au premier noeud de mémorisation pour générer un premier courant d'écriture dans le premier transistor et le premier élément à commutation de résistance.

Selon un autre mode de réalisation, le circuit de commande est en outre adapté à isoler le deuxième noeud de mémorisation de la deuxième tension d'alimentation, puis à appliquer, pendant une phase de programmation du deuxième élément à commutation de résistance, la deuxième tension d'alimentation au deuxième noeud de mémorisation pour générer un deuxième courant d'écriture dans le deuxième transistor et le deuxième élément à commutation de résistance.

Selon un autre mode de réalisation, la mémoire comprend en outre un troisième transistor couplant le premier noeud de mémorisation à la deuxième tension d'alimentation et un quatrième transistor couplant le deuxième noeud de mémorisation à la deuxième tension d'alimentation.

Selon un autre mode de réalisation, le troisième transistor est adapté à avoir une tension de seuil inférieure à celle du premier transistor et le quatrième transistor est adapté à avoir une tension de seuil inférieure à celle du deuxième transistor.

Selon un autre mode de réalisation, ladite au moins une cellule mémoire comprend en outre un cinquième transistor couplé entre les premier et deuxième noeuds de mémorisation.

Selon un autre mode de réalisation, le dispositif reprogrammable comprend en outre : une pluralité desdits pavés élémentaires ; et un contrôleur adapté à contrôler au moins l'activation de la mémoire de chacun des pavés élémentaires et le rafraîchissement des données de configuration de chacun des pavés.

Selon un autre mode de réalisation, les premier et deuxième éléments à commutation de résistance sont d'un des types suivants : des éléments à commutation assistée thermiquement (TAS) ; des éléments résistifs à oxyde ; des éléments à pontage conducteur ; des éléments à changement de phase ; des éléments à métallisation programmable ; des éléments à transfert de spin ; et des éléments à commutation magnétique induite par champ (FIMS).

Selon un autre aspect, on prévoit un procédé pour rafraîchir un dispositif reprogrammable selon la revendication indépendante 15.

### Brève description des dessins

Les objets, caractéristiques, aspects et avantages susmentionnés de l'invention, et d'autres, apparaîtront clairement à la lecture de la description détaillée suivante de modes de réalisation, donnés à titre d'illustration et non de limitation en référence aux figures jointes, parmi lesquelles :
la figure 1 illustre schématiquement une partie d'un dispositif à mémoire reprogrammable selon un exemple de réalisation ;
la figure 2 illustre schématiquement plus en détail un pavé élémentaire de la figure 1 selon un exemple de réalisation ;
la figure 3A illustre schématiquement plus en détail une partie du pavé de la figure 2 selon un exemple de réalisation ;
la figure 3B illustre schématiquement plus en détail une table de correspondance de la figure 3A selon un exemple de réalisation ;
la figure 3C illustre schématiquement plus en détail une cellule de mémoire volatile de la figure 3B selon un exemple de réalisation ;
la figure 3D illustre schématiquement plus en détail un commutateur de routage programmable du pavé élémentaire de la figure 2 selon un exemple de réalisation ;
la figure 4 illustre schématiquement plus en détail une mémoire magnétorésistive à accès aléatoire (MRAM) du pavé élémentaire de la figure 2 selon un exemple de réalisation ;
la figure 5A illustre schématiquement plus en détail la MRAM de la figure 4 selon un exemple de réalisation ;
la figure 5B illustre schématiquement un circuit de contrôle d'écriture du circuit de la figure 5A selon un exemple de réalisation ;
les figures 6A et 6B illustrent des éléments à commutation de résistance de la MRAM de la figure 5A selon un exemple de réalisation ;
la figure 7 est un chronogramme représentant des signaux présents dans la MRAM de la figure 5A selon un exemple de réalisation ;
la figure 8 illustre schématiquement plus en détail un module de lecture/écriture de la MRAM de la figure 4 selon un autre exemple de réalisation ; et
la figure 9 est un chronogramme représentant des signaux présents dans une MRAM comprenant le module de lecture/écriture de la figure 8.

Dans les dessins, sauf mention contraire, de mêmes références désignent de mêmes éléments.

### Description détaillée

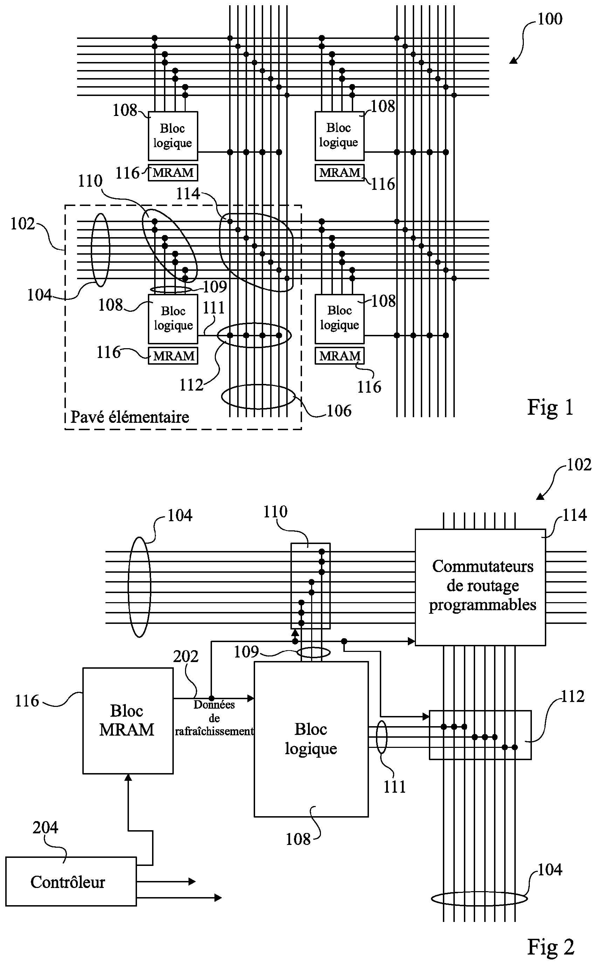

La figure 1 illustre une partie d'un dispositif reprogrammable 100 selon un exemple de réalisation.

Dans l'exemple de la figure 1, le dispositif est un FPGA (réseau de portes programmable sur site) constitué d'un réseau de pavés élémentaires 102, dont quatre pavés adjacents sont illustrés. En pratique, il peut y avoir beaucoup plus que quatre pavés dans le dispositif logique reprogrammable, par exemple des milliers de pavés.

Chacun des pavés 102 comprend des lignes de rangées 104 et des lignes de colonnes 106, qui, dans l'exemple de la figure 1, sont au nombre de huit lignes de rangée 104 et huit lignes de colonne 106, bien que dans des variantes de réalisation il puisse y avoir un nombre différent, par exemple 16, 32 ou 64, de lignes de rangée et de colonne.

Chaque pavé 102 comprend aussi un bloc logique 108 adapté à réaliser une fonction logique. Dans l'exemple de la figure 1, le bloc logique comprend quatre lignes d'entrée 109, chacune d'elle pouvant être connectée sélectivement à l'une des lignes de rangée 104. En particulier, une interconnexion programmable 110 est prévue, celle-ci permettant à chacune des lignes d'entrée 109 d'être connectée à l'une sélectionnée des lignes de rangée 104, et dans l'exemple de la figure 1, chacune des quatre lignes d'entrée 109 peut être connectée à une ligne d'une paire différente des huit lignes de rangée 104.

Le bloc logique 108 réalise une fonction logique sur les données présentes sur les lignes d'entrée 109 pour générer des données en sortie sur une ligne de sortie 111. La ligne de sortie 111 peut être sélectivement connectée à l'une des lignes de colonne 106. En particulier, une interconnexion programmable 112 est prévue et permet à la ligne de sortie 111 d'être connectée à l'une sélectionnée des lignes de colonne 106, et dans l'exemple de la figure 1, la ligne de sortie 111 peut être couplée à l'une d'une première, troisième, cinquième ou septième des lignes de colonne 106.

Chacun des pavés 102 comprend en outre des commutateurs de routage programmables 114, permettant à chacune des lignes de rangée 104 d'être connectée sélectivement à des lignes de rangée et/ou de colonne correspondantes de pavés adjacents. En particulier, dans l'exemple de la figure 1, les commutateurs de routage programmables 114 permettent à chacune des lignes de rangée 104 d'être connectée à une ligne de rangée correspondante du pavé situé à droite dans la figure, à une ligne de colonne correspondante du pavé situé au-dessus dans la figure, et/ou à une ligne de colonne correspondante du pavé situé en dessous dans la figure.

Chacun des pavés 102 comprend en outre une MRAM (mémoire magnétorésistive à accès aléatoire) 116. La MRAM 116 mémorise des données de configuration qui configurent les interconnexions 110, 112 et le commutateur 114, ainsi que la fonction logique appliquée par le bloc logique 108.

La figure 2 illustre plus en détail le pavé 102 de la figure 1 selon un exemple de réalisation. Comme cela est illustré, la MRAM 116 fournit des données de rafraîchissement, sur une ligne 202, au bloc logique 108, aux interconnexions programmables 110 et 112, et au commutateur de routage programmable 114. Dans l'exemple de la figure 2, le bloc logique 108 comprend trois lignes d'entrée 109 et trois lignes de sortie 111, et chacune des interconnexions 110 et 112 permet de connecter sélectivement deux des lignes d'entrée/sortie respectives à une ligne d'un groupe correspondant de trois des lignes de rangée/colonne 104, 106, et de connecter sélectivement la troisième de ces lignes d'entrée/sortie respectives à une ligne d'un groupe correspondant de deux des lignes de rangée et de colonne 104, 106.

Un contrôleur 204, qui par exemple ne fait pas partie du pavé 102, fournit des signaux de commande à la MRAM 116, et fournit aussi par exemple des signaux de commande à d'autres MRAM 116 d'autres pavés du dispositif logique reprogrammable.

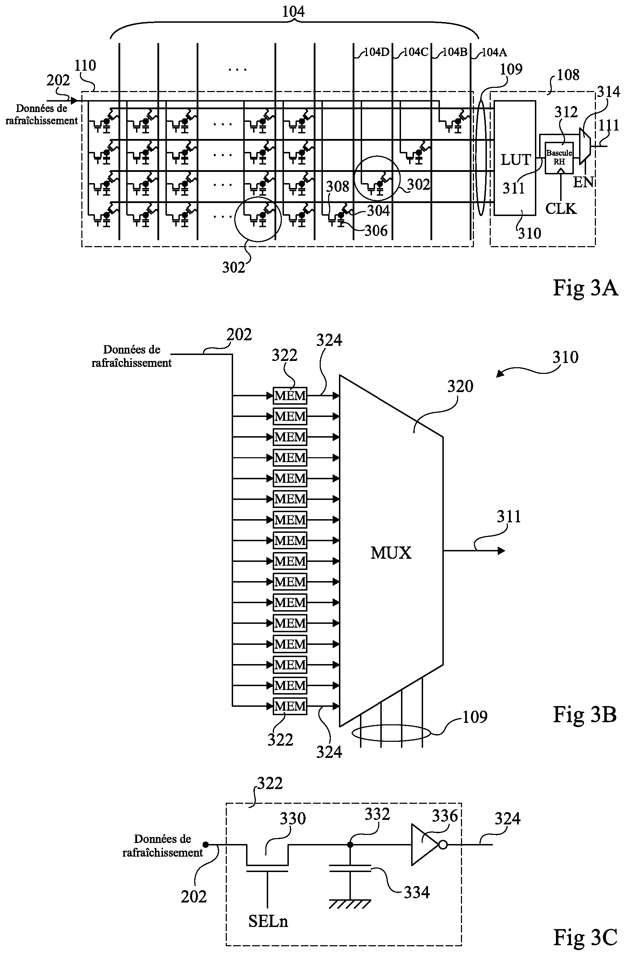

La figure 3A illustre plus en détail l'interconnexion programmable 110 et le bloc logique 108 de la figure 1, selon un exemple de réalisation. Comme cela est illustré, dans cet exemple, il y a quatre lignes d'entrée 109 vers le bloc logique 108, et plus de huit lignes de rangée 104. L'interconnexion programmable 110 comprend un noeud programmable 302 au niveau de l'intersection de chaque ligne d'entrée 109 et de chaque ligne de rangée 104, où une connexion peut être programmée. Dans l'exemple de la figure 3A, chacune de quatre lignes de rangée 104A à 104D est connectée sélectivement par des noeuds programmables 302 à chacune de quatre lignes d'entrée 109, respectivement. Les autres lignes de rangée sont par exemple connectées, chacune sélectivement, par des noeuds programmables 302 à chacune des lignes d'entrée 109.

Chacun des noeuds programmables 302 comprend une cellule de mémoire volatile, comme une cellule DRAM. En particulier, chaque noeud 302 comprend un transistor 304, par exemple un transistor MOS à canal N (NMOS), couplé par ses noeuds de courant principaux entre la ligne de rangée et la ligne d'entrée correspondantes, et ayant sa grille couplée à la masse par l'intermédiaire d'une capacité 306 et à la ligne de données de rafraîchissement 202 par l'intermédiaire d'un transistor de sélection 308, qui ici encore est un transistor NMOS. Bien que cela ne soit pas illustré en figure 3A, le transistor 308 de chaque noeud programmable reçoit un signal de sélection correspondant SELn, décrit plus en détail ci-après. La capacité 306 peut correspondre à un petit condensateur, par exemple dans la plage de 1 à 100 fF ou alternativement il peut correspondre à des capacités parasites associées aux transistors 304 et 308.

Le bloc logique 108 comprend par exemple une table de correspondance 310, ayant dans cet exemple une seule ligne de sortie 311 couplée à une bascule 312, qui est par exemple une bascule RH (résistant aux rayonnements), et à une entrée d'un multiplexeur à deux entrées 314. La sortie de la bascule 312 est couplée à l'autre entrée du multiplexeur 314, et la sortie du multiplexeur 314 fournit le signal de sortie sur la ligne 111 du bloc logique 108. Le multiplexeur 314 est contrôlé par un signal EN, décrit plus en détail ci-après. Ainsi, le multiplexeur 314 est par exemple contrôlé de telle sorte que, lorsque le pavé 102 est activé, il va avoir soit un comportement séquentiel si la sortie de la bascule 312 est sélectionnée, soit un comportement combinatoire si la sortie de la table de correspondance 310 est sélectionnée. Lorsque le pavé est désactivé, la bascule 312 va être dans un état déterminé et constant.

La figure 3B illustre plus en détail la table de correspondance 310 de la figure 3A. Comme cela est illustré, la table de correspondance 310 comprend par exemple un multiplexeur 320, qui reçoit les lignes d'entrée 109 en tant que signaux de sélection. Dans le cas d'une table de correspondance ayant quatre lignes d'entrée 109, le multiplexeur comporte par exemple 16 lignes d'entrée 324, chacune étant par exemple couplée à une cellule de mémoire volatile 322, qui reçoit le signal de données de rafraîchissement sur la ligne 202.

La figure 3C illustre plus en détail l'une des cellules de mémoire volatile 322, qui sont par exemple des cellules DRAM. Comme cela est illustré, la cellule 322 comprend par exemple un transistor 330, par exemple un transistor NMOS, couplé entre la ligne de données de rafraîchissement 222 et un noeud 332. La grille du transistor 330 reçoit un signal de sélection SELn, décrit plus en détail ci-après. Le noeud 332 est en outre couplé à la masse par l'intermédiaire d'une capacité 334, et à la ligne d'entrée 324 du multiplexeur 320 par l'intermédiaire d'un inverseur 336. La capacité 334 est par exemple un petit condensateur, par exemple dans la plage de 1 à 100 fF, ou en variante il peut correspondre aux capacités parasites associées au transistor 332 et à l'inverseur 336.

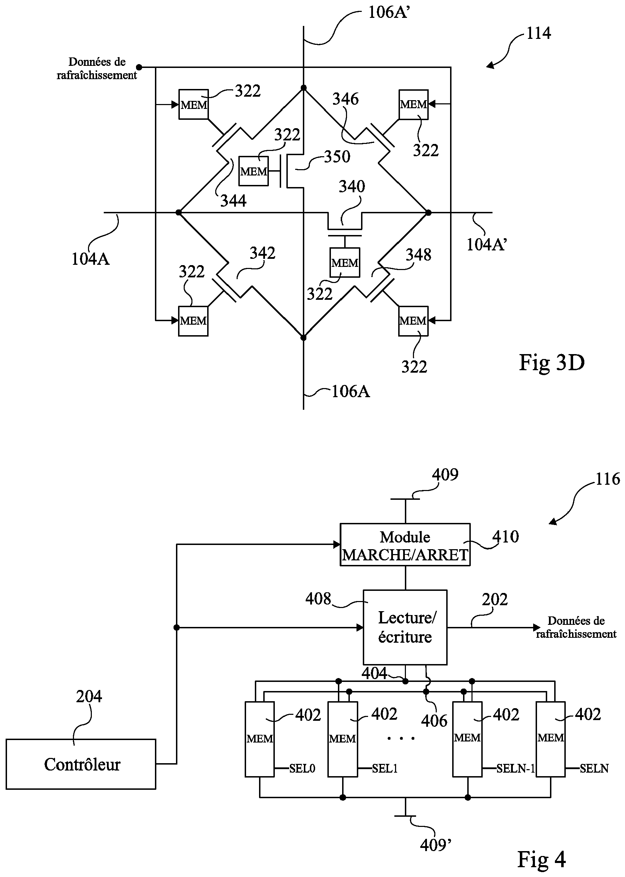

La figure 3D illustre plus en détail le commutateur de routage programmable 114 selon un exemple. Comme cela est illustré, le commutateur 114 reçoit dans cet exemple une première ligne de rangée 104A et une première ligne de colonne 106A d'un pavé 102, et aussi une première ligne de rangée 104A' d'un pavé situé vers la droite (non illustré en figure 3D), et une première ligne de colonne 106A' d'un pavé situé au-dessus (pas illustré non plus en figure 3D). La ligne 104A est couplée à la ligne 104A' par l'intermédiaire d'un transistor 340, à la ligne 106A par l'intermédiaire d'un transistor 342, et à la ligne 106A' par l'intermédiaire d'un transistor 344. La ligne 104A' est couplée à la ligne 106A' par l'intermédiaire d'un transistor 346 et à la ligne 106A par l'intermédiaire d'un transistor 348. La ligne 106A est couplée à la ligne 106A' par l'intermédiaire d'un transistor 350. Chacun des transistors 340 à 350 est par exemple un transistor NMOS, et chacun a sa grille couplée à une cellule de mémoire volatile 322 correspondante, qui correspond par exemple à la cellule mémoire illustrée en figure 3C, mais sans l'inverseur 336. Chaque cellule mémoire 322 reçoit le signal de données de rafraîchissement sur la ligne 202.

Ainsi, comme cela a été décrit précédemment en relation avec les figures 3A à 3D, les diverses cellules de mémoire volatile sont utilisées pour configurer des connexions ou des valeurs de données utilisées par le pavé 102, et le bit de données de configuration mémorisé par chaque cellule est rafraîchi par l'intermédiaire d'un transistor de chaque cellule mémoire contrôlé par un signal de sélection SELn correspondant. En supposant un nombre total N+1 de cellules de mémoire volatile dans le pavé 102, il y a ainsi des signaux de sélection SELO à SELN pour contrôler chacune des cellules mémoires. Une opération de rafraîchissement basée sur ces signaux de sélection va maintenant être décrite en référence à la figure 4.

La figure 4 illustre plus en détail la MRAM 116 de la figure 2 selon un exemple de réalisation. Comme cela est illustré, la MRAM 116 comprend une série de cellules de mémoire non volatile 402, chacune d'elles recevant l'un correspondant des signaux de sélection SELO à SELN. Les cellules mémoires 402 sont couplées, en parallèle, aux noeuds 404 et 406, qui à leur tour sont couplés à des entrées correspondantes d'un module de lecture/écriture 408, qui est alimenté par un rail de tension d'alimentation 409 par l'intermédiaire d'un module MARCHE/ARRET 410. En outre, chacune des cellules mémoires 402 est par exemple couplée à un autre rail de tension d'alimentation 409'. Une tension d'alimentation positive ou négative est appliquée entre les rails 409, 409'. Dans certains modes de réalisation, la polarité de cette tension d'alimentation peut être utilisée pour générer un courant d'écriture dans les cellules mémoires 402 dans une direction ou dans l'autre, pour programmer les cellules mémoires. A titre de variante, la polarité de la tension d'alimentation peut être constante, et on utilise une technique différente pour programmer les cellules mémoires, comme cela va être décrit plus en détail ci-après.

Comme cela est illustré en figure 4, le module de lecture/écriture 408 et le module MARCHE/ARRÊT 410 sont contrôlés par le contrôleur 204. Le module de lecture/écriture 408 fournit les données de rafraîchissement sur la ligne 202.

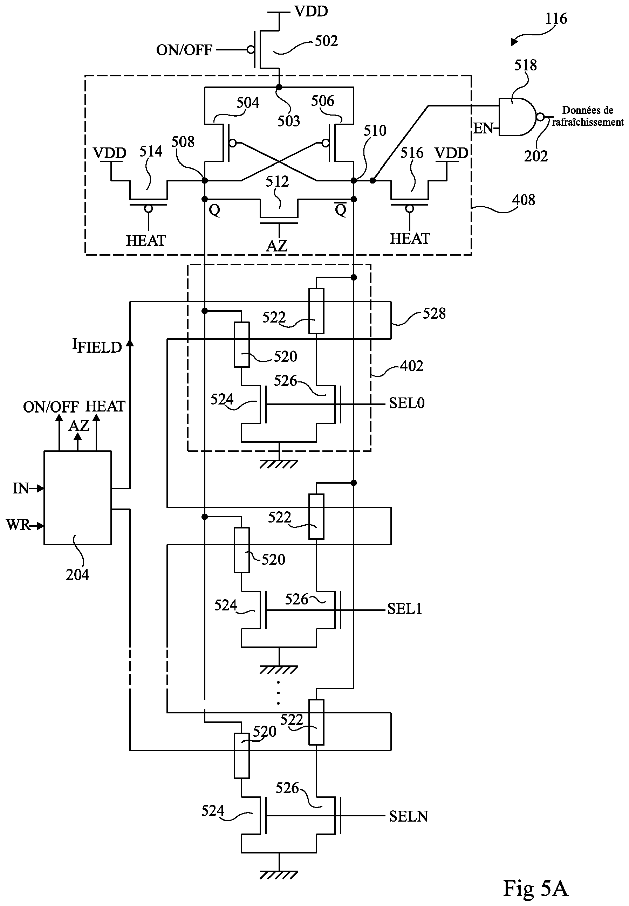

La figure 5A illustre la MRAM 116 encore plus en détail selon un exemple de réalisation dans lequel le rail de tension d'alimentation 409 est à VDD, et chacune des cellules mémoires 402 est couplée à la masse. En outre, dans cet exemple, les cellules mémoires sont des éléments à commutation magnétique induite par champ (FIMS) programmés par un champ magnétique, comme on va le décrire plus en détail ci-après.

Comme cela est illustré, le module MARCHE/ARRÊT 410 comprend un transistor PMOS 502 qui a avantageusement un faible courant de fuite, couplé entre VDD et un noeud 503, et qui reçoit sur sa grille un signal de commande ON/OFF provenant du contrôleur 204.

Le module de lecture/écriture 408 comprend une bascule constituée de deux transistors 504, 506, qui sont par exemple des transistors PMOS. Le transistor 504 a sa source couplée au noeud 503, et son drain couplé à un noeud 508. De façon similaire, le transistor 506 a sa source couplée au noeud 503, et son drain couplé à un noeud 510. La grille du transistor 506 est couplée au noeud 508, et la grille du transistor 504 est couplée au noeud 510. Un transistor 512, qui est par exemple un transistor NMOS, est couplé entre les noeuds 508 et 510, et contrôlé au niveau de sa grille par un signal AZ fourni par le contrôleur 204. Le noeud 508 est en outre couplé à la tension d'alimentation VDD par l'intermédiaire d'un transistor 514, et le noeud 510 est en outre couplé à la tension d'alimentation VDD par l'intermédiaire d'un transistor 516. Les transistors 514 et 516 sont par exemple des transistors PMOS, et reçoivent sur leur grille un signal HEAT provenant du contrôleur 204.

Le noeud 510 fournit les données de rafraîchissement sur la ligne 202, après les avoir fournies à une porte NON ET 518, qui reçoit aussi un signal d'activation EN sur sa deuxième entrée.

Les noeuds 508 et 510 mémorisent respectivement des états logiques Q et Q̅, et sont couplés aux cellules de mémoire non volatile 402. La figure 5A illustre un exemple de ces cellules. Chaque cellule 402 comprend par exemple deux éléments à commutation de résistance 520, 522. L'élément à commutation de résistance 520 a une borne couplée au noeud 508, et une autre borne couplée à la masse par l'intermédiaire d'un transistor 524. L'élément à commutation de résistance 522 a une borne couplée au noeud 510, et une autre borne couplée à la masse par l'intermédiaire d'un transistor 526. Les transistors 524, 526 sont par exemple des transistors NMOS, et reçoivent sur leur grille le signal de sélection SELn, chaque cellule correspondant à l'une des cellules de mémoire volatile décrite précédemment.

Les éléments à commutation de résistance 520 et 522 de chaque cellule 402 peuvent être tout élément résistif commutable entre deux valeurs de résistance. De tels éléments maintiennent l'état programmé même après le retrait de la tension d'alimentation. Les éléments à commutation de résistance 520, 522 sont par exemple programmés pour avoir des valeurs opposées (Rmin, Rmax), et les valeurs relatives des éléments indiquent une valeur de donnée binaire.

Par exemple, les éléments à commutation de résistance 520, 522 sont basés sur des jonctions tunnel magnétiques (MTJ), comme des éléments à commutation magnétique induite par champ (FIMS), des éléments à commutation assistée thermiquement (TAS), des éléments STT (à transfert de spin), ou des éléments de MRAM à bascule. Des FIMS-MRAM (mémoire magnétique à accès aléatoire) sont par exemple décrits plus en détail dans la publication intitulée "Magnetoresistive random access memory using magnetic tunnel junctions", S. Tehrani, Proceedings of IEEE, 91(5):3707-714, mai 2003. Des TAS-MRAM sont par exemple décrits plus en détail dans la publication intitulée "Thermally Assisted MRAM", Prejbeanu et al.

A titre de variante, les éléments à commutation de résistance 202, 204 pourraient être d'autres types de dispositifs à mémoire, comprenant des mémoires résistives comme celles qui sont utilisées dans des cellules à métallisation programmable (PMC), comme de la RAM résistive à oxyde (OxRRAM), de la RAM à pontage conducteur (CBRAM) ou de la RAM à changement de phase (PCRAM).

Quel que soit le type de l'élément à commutation de résistance, l'information est mémorisée en mettant l'un des éléments à une résistance relativement élevée (Rmax), et l'autre à une résistance relativement faible (Rmin). Chacun des éléments à commutation de résistance 520, 522 ne comporte par exemple que seulement deux états résistifs correspondant aux résistances haute et basse Rmax et Rmin, bien que les valeurs exactes de Rmin et de Rmax puissent varier en fonction de conditions telles que la température, les variations de processus, etc. La valeur de donnée non volatile représentée par les éléments résistifs 520, 522 dépend de celui des éléments résistifs qui a la résistance Rmax ou Rmin, en d'autres termes des résistances relatives. Les éléments à résistance 520, 522 sont par exemple sélectionnés de telle sorte que Rmax soit toujours notablement supérieure à Rmin, par exemple supérieure d'au moins 20 %. En général, le rapport entre la résistance Rmax et la résistance Rmin est par exemple compris entre 1,7 et 5 pour une MRAM, ou plus généralement entre 1,2 et 10000. Dans un exemple, Rmin est dans la région de 2,5 kilo-ohms, et Rmax est dans la région de 5 kilo-ohms, bien que de nombreuses autres valeurs soient possibles.

Dans un exemple, les éléments à commutation de résistance 520, 522 sont chauffés par l'application du signal HEAT aux transistors 514 et 516, puis programmés par la direction d'un champ magnétique généré en faisant passer un courant I_{FIELD} dans une direction ou l'autre dans une piste conductrice 528 passant à proximité de chaque élément à commutation de résistance 520, 522 de chacune des cellules 402. Comme cela est illustré en figure 5A, la piste conductrice 528 est par exemple couplée au contrôleur 204, qui fournit le courant pour programmer les éléments.

Le contrôleur 204 reçoit par exemple un signal d'écriture WR indiquant le moment où les cellules non volatiles 402 doivent être programmées, et un signal de données IN indiquant la donnée à programmer dans chaque cellule.

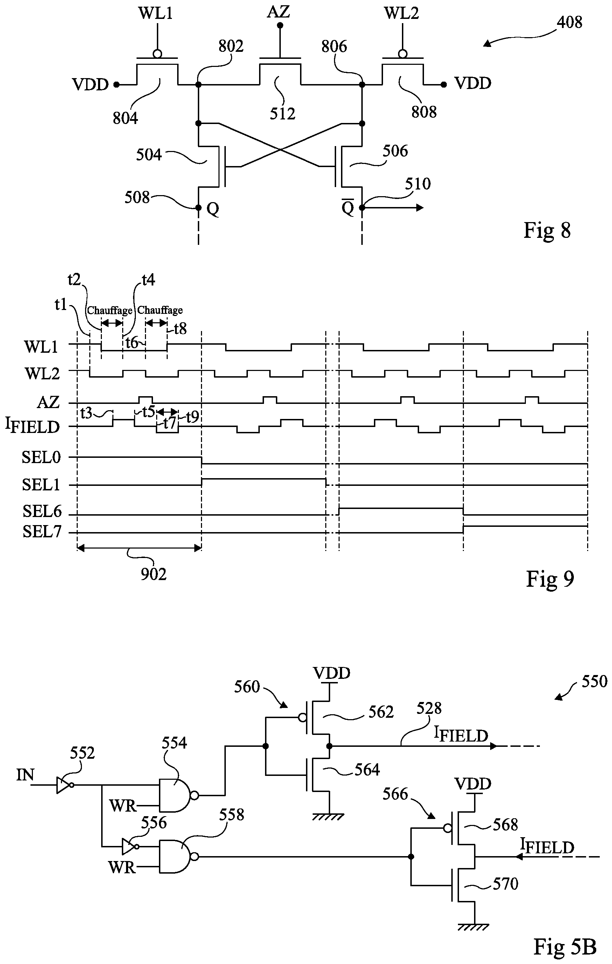

La figure 5B illustre un exemple de circuit 550 faisant partie du contrôleur 204 pour générer le signal I_{FIELD} sur la base des signaux d'entrée IN et WR.

Comme cela est illustré, le signal de données IN est couplé par l'intermédiaire d'un inverseur 552 à une entrée d'une porte NON ET à deux entrées 554, et par l'intermédiaire de l'inverseur 552 et d'un autre inverseur 556 à une entrée d'une porte NON ET à deux entrées 558. Chacune des autres entrées des portes 554 et 558 est couplée de façon à recevoir le signal d'écriture WR. La sortie de la porte NON ET 554 est couplée à un inverseur 560 constitué d'un transistor PMOS 562 et d'un transistor NMOS 564 couplés en série entre la tension d'alimentation VDD et la masse. Un noeud intermédiaire entre les transistors 562 et 564 est couplé à une extrémité de la piste conductrice 528. La sortie de la porte NON ET 558 est couplée à un inverseur 566 constitué d'un transistor PMOS 568 et d'un transistor NMOS 570 couplés en série entre la tension d'alimentation VDD et la masse. Un noeud intermédiaire entre les transistors 568 et 570 est couplé à l'autre extrémité de la piste conductrice 528.

En fonctionnement, lorsque le signal d'écriture WR est affirmé, une valeur logique basse du signal d'entrée IN va provoquer le passage d'un courant positif I_{FIELD} à partir de l'inverseur 560 vers l'inverseur 566, alors qu'une valeur logique haute du signal d'entrée IN va provoquer le passage d'un courant négatif I_{FIELD} à partir de l'inverseur 566 vers l'inverseur 560.

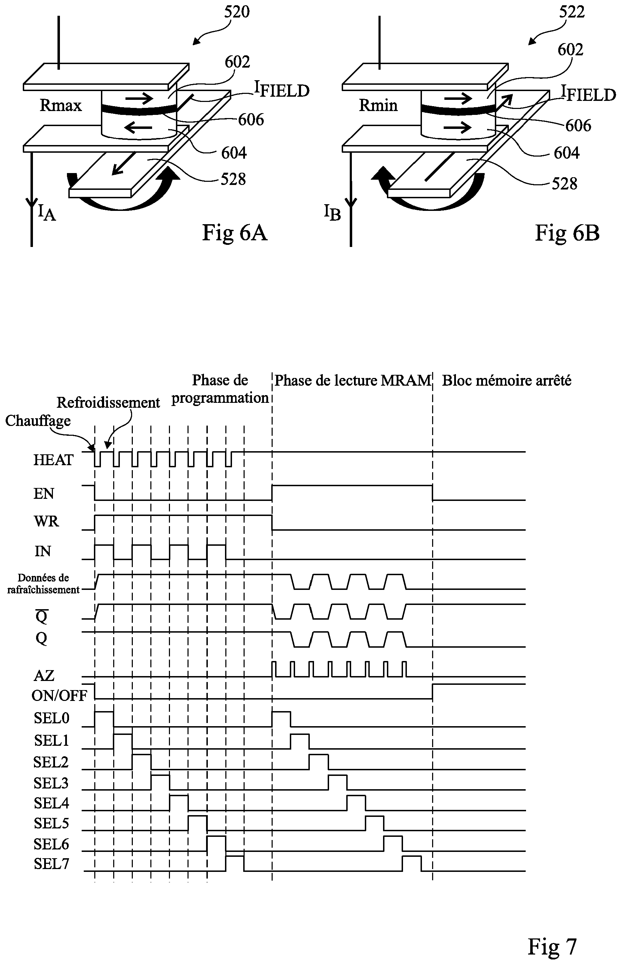

Les figures 6A et 6B représentent plus en détail les éléments à commutation de résistance 520, 522 dans l'exemple où ce sont des éléments TAS. Chacun des éléments à commutation de résistance 520, 522 comprend une plaque ferromagnétique fixe 602 et une plaque ferromagnétique libre 604, les plaques 602 et 604 prenant en sandwich une couche d'oxyde tunnel 606. La piste conductrice 528 passe près de la plaque libre 604 en matériau ferromagnétique, de sorte qu'elle est affectée par le champ magnétique généré par le courant I_{FIELD} passant dans la piste 528. La plaque fixe 602 a par exemple une orientation magnétique dans une première direction, alors que l'orientation magnétique de la plaque 604 peut être programmée, par la polarité du courant I_{FIELD}, pour être dans la même direction ou dans la direction opposée à celle de la plaque 602. Cependant, une programmation n'a lieu que dans des éléments qui ont été déjà chauffés, comme cela est décrit plus en détail ci-après.

La figure 6A illustre le cas où les orientations magnétiques ont des directions opposées dans les plaques 602, 604, ce qui entraîne une résistance maximum Rmax pour l'élément à commutation de résistance 520, par exemple dans une plage de 2 kilo-ohms à 5 kilo-ohms.

La figure 6B illustre le cas où les orientations magnétiques ont la même direction dans les plaques 602 et 604, ce qui entraîne une résistance minimum Rmin pour l'élément à commutation de résistance 522, par exemple dans une plage de 100 ohms à 3 kilo-ohms.

La piste conductrice 528 est agencée de telle sorte que le courant I_{FIELD} passe par chaque élément à commutation de résistance 520, 522 dans des directions opposées, l'une d'elle correspondant à l'orientation magnétique de la plaque fixe 602, et l'autre étant l'orientation opposée. Ainsi, un même courant I_{FIELD} peut être utilisé pour programmer les états résistifs des deux éléments à commutation de résistance 520 et 522 en même temps, l'un d'eux étant égal à Rmax et l'autre à Rmin.

On va maintenant décrire, en faisant référence à la figure 7, le fonctionnement de la MRAM 116 de la figure 5A pendant une phase de programmation des cellules de mémoire non volatile, pendant une phase de lecture de la MRAM, et pendant une phase d'arrêt.

La figure 7 est un chronogramme illustrant des exemples des signaux HEAT, EN, WR, IN, Données de rafraîchissement, Q, Q̅, AZ, ON/OFF, et des huit signaux de sélection SEL0 à SEL7. Les signaux HEAT, EN, AZ, ON/OFF et les signaux de sélection sont par exemple générés par le contrôleur 204. On supposera en figure 7 qu'il y a huit cellules de mémoire non volatile 402, et ainsi 8 cellules de mémoire volatile correspondantes dans le pavé à programmer. En pratique, il peut y avoir beaucoup plus de cellules de mémoire volatile mémorisant des données de configuration, par exemple des centaines ou des milliers.

Pendant la phase de programmation, le signal HEAT passe à l'état bas pour activer les transistors de chauffage 514 et 516, et le signal de sélection SEL0 pour la première cellule 402 passe à l'état haut. Ainsi, un courant de chauffage passe dans les éléments à commutation de résistance 520, 522 de la première cellule mémoire 402. En même temps, une valeur haute du signal de données d'entrée IN et du signal d'écriture WR entraîne le passage du courant I_{FIELD} dans une première direction, programmant un état résistif correspondant des éléments à commutation de résistance 520, 522 de la première cellule mémoire 402. Le signal HEAT passe ensuite à l'état haut, et après une période de refroidissement, le signal de sélection SEL0 passe à l'état bas, terminant la phase de programmation de la première cellule mémoire. Les signaux de sélection SEL1 à SEL7 sont ensuite successivement activés, et les cellules mémoires correspondantes sont programmées de façon similaire, sur la base de valeurs successives du signal de données d'entrée IN.

Dans une variante de réalisation, on pourrait programmer en même temps plusieurs des cellules de mémoire non volatile 402. En particulier, dans l'exemple de la figure 7, les cellules mémoires correspondant aux signaux de sélection SELO, SEL2, SEL4 et SEL6 doivent toutes être programmées sur la base d'une valeur logique haute du signal d'entrée IN, et ainsi les signaux de sélection SEL2, SEL4 et SEL6 pourraient être affirmés aussi pendant que le signal de sélection SEL0 est affirmé, afin que toutes ces cellules soient programmées en une seule passe. Les cellules mémoires restantes, qui doivent être programmées sur la base d'une valeur logique basse du signal d'entrée IN, pourraient alors être programmées ensemble en affirmant les signaux de sélection SEL1, SEL3, SEL5 et SEL7 en même temps pendant une opération d'écriture suivante. Ainsi, tous les éléments pourraient être programmés en seulement deux opérations d'écriture. Dans un tel mode de réalisation, la taille de chacun des transistors 514 et 516 est par exemple adaptée de façon à ce qu'ils fournissent un courant suffisant pour chauffer tous les éléments 520, 522 qui doivent être programmés en même temps. En outre, le contrôleur 204 est par exemple adapté à sélectionner les cellules mémoires dans lesquelles la même valeur de donnée doit être écrite.

En faisant de nouveau référence à la figure 7, pendant la phase de lecture MRAM suivante, les données mémorisées dans les cellules de mémoire non volatile 408 sont utilisées pour rafraîchir les bits de données de configuration correspondants dans les cellules de mémoire volatile. Pour cela, le signal de chauffage reste à l'état haut, désactivant les transistors 514, 516, le signal EN passe à l'état haut, activant la porte NON ET de sortie 518, et le signal d'écriture WR passe à l'état bas, désactivant le courant I_{WRITE}. Ensuite, chacun des signaux de sélection SEL0 à SEL7 est activé tour à tour, entraînant que les valeurs de Q et Q̅ prennent des valeurs qui dépendent de celui des éléments à commutation de résistance de chaque cellule mémoire qui a la résistance Rmin et de celui qui a la résistance Rmax. Par exemple, en supposant que dans la première cellule mémoire 402 l'élément à commutation de résistance 520 soit programmé pour être à Rmax, et que l'élément à commutation de résistance 522 soit programmé pour être à Rmin, lors de l'activation du signal de sélection SELO, le niveau de tension Q̅ va être tiré à l'état bas par le chemin à faible résistance vers la masse assuré par l'élément 522, alors que Q va rester à l'état haut, en raison de la résistance relativement élevée présentée par l'élément 520. Ainsi, le signal de données de rafraîchissement va passer à l'état haut, et la cellule de mémoire volatile correspondante, qui est aussi sélectionnée par le signal de sélection SELO, va être rafraîchie avec ce niveau logique haut. Au début de l'opération de lecture de chaque cellule mémoire 402, le transistor 512 est par exemple activé par le signal AZ pendant une courte période pour égaliser momentanément les tensions Q et Q̅, et aider la transition vers les nouveaux états déterminés par les résistances programmées des éléments 520, 522.

Pendant une phase d'arrêt suivante de la MRAM, le signal ON/OFF est amené à l'état haut, désactivant par cela le transistor 502, et le signal d'activation EN est amené à l'état bas, amenant à l'état bas la sortie du signal de données de rafraîchissement. Dans cet état, la consommation d'énergie de la MRAM est très faible, mais les états programmés des cellules de mémoire non volatile 402 vont être maintenus.

La MRAM 402 est par exemple périodiquement activée et utilisée pour rafraîchir les cellules de mémoire volatile du pavé 102 correspondant du dispositif de mémoire reprogrammable. Le rafraîchissement survient par exemple une fois toutes les T secondes, T étant compris entre 1 et 100 ms.

La figure 8 illustre le module de lecture/écriture 408 selon une variante de réalisation dans laquelle il n'y a pas de module MARCHE/ARRET ni de transistors de chauffage. A la place, un noeud 802 est couplé à la tension d'alimentation VDD par l'intermédiaire d'un transistor PMOS 804, et un noeud 806 est couplé à la tension d'alimentation VDD par l'intermédiaire d'un transistor PMOS 808. Le transistor 804 est contrôlé par un signal WL1, tandis que le transistor 808 est contrôlé par un signal WL2. Le transistor 504 de la bascule est couplé entre le noeud 802 et un noeud 508, et a sa grille couplée au noeud 806. Le transistor 506 de la bascule est couplé entre le noeud 806 et un noeud 510, et a sa grille couplé au noeud 802.

La bascule formée par les transistors 504 et 506 en figure 8 est couplée à la masse par l'intermédiaire de l'une sélectionnée des cellules mémoires 402, mais ne comprend pas de connexion directe à la tension d'alimentation VDD. A la place, les transistors 804 et 808 sont adaptés pour avoir une tension de seuil inférieure à celle des transistors 504 et 506. De cette façon, le courant de fuite dans les transistors 804 ou 808 va maintenir un état logique haut sur l'un des noeuds 802, 806 lorsque les transistors 804 et 808 ne sont pas activés.

On va maintenant décrire plus en détail en référence à la figure 9 le fonctionnement du module de lecture/écriture 408 de la figure 8.

La figure 9 est un chronogramme représentant des exemples des signaux WL1, WL2, AZ, I_{FIELD} et des signaux de sélection SEL0 à SEL7 pendant la phase de programmation des cellules de mémoire non volatile 402. Ces signaux sont par exemple générés par une circuiterie du contrôleur 204. Ici encore on supposera qu'il y a seulement huit cellules de mémoire volatile mémorisant des données de configuration dans le pavé.

Initialement, pendant une première période d'écriture 902 pour programmer la cellule mémoire associée au signal de sélection SELO, ce signal de sélection est affirmé. Les signaux WL1 et WL2 sont initialement à l'état haut, de sorte que les transistors 804 et 808 ne sont pas activés. Le signal WL2 est ensuite amené à l'état bas à un instant t1, ce qui active le transistor 808 et active aussi le transistor 504. Le signal WL1 passe à l'état bas peu après à l'instant t2, ce qui active le transistor 804, et entraîne le passage d'un courant de chauffage dans l'élément à commutation de résistance 520. Le signal de courant I_{FIELD} est ensuite affirmé à un instant t3, dans une direction négative ou positive en fonction de la donnée à programmer pour l'élément 520. Dans l'exemple de la figure 9, le signal I_{FIELD} passe à une valeur positive, correspondant par exemple à la programmation d'une valeur de bit "1" du signal de données d'entrée IN. A un instant t4, le signal WL2 passe à l'état haut, arrêtant par cela le courant de chauffage, et à un instant t5, après une période de refroidissement, le signal I_{FIELD} revient à un niveau neutre, dans lequel par exemple aucun courant ne passe. Le signal AZ est ensuite par exemple brièvement affirmé, pour égaliser les tensions Q et Q̅, avant que le signal WL2 ne passe de nouveau à l'état haut à un instant t6, provoquant le passage d'un courant de chauffage dans le transistor 506. Le signal AZ passe par exemple à l'état bas peu après le front descendant du signal WL2. Ensuite, à un instant t7, le signal de courant I_{FIELD} est alors affirmé pour programmer l'élément 522, le courant étant appliqué dans la direction opposée à la direction du courant pour programmer l'élément 520. Ainsi, le signal I_{FIELD} passe à une valeur négative dans l'exemple de la figure 9. Le signal WL1 passe ensuite à l'état haut à un instant t8, arrêtant le courant de chauffage, et à un instant t9, après une période de refroidissement, le signal I_{FIELD} revient à un niveau neutre, dans lequel par exemple aucun courant ne passe. Finalement, le signal WL2 passe à l'état haut, isolant le circuit de lecture/écriture de la tension d'alimentation, prêt pour une opération de programmation de la cellule mémoire suivante à programmer.

Cette procédure de programmation est répétée pendant des phases d'écriture suivantes pour chacune des cellules mémoires.

Un avantage des modes de réalisation décrits ici est que, en utilisant une mémoire volatile pour mémoriser des données de configuration dans chaque pavé élémentaire d'un dispositif logique reprogrammable, et aussi en utilisant une mémoire non volatile dans le pavé élémentaire comprenant une pluralité d'éléments à commutation de résistance pour rafraîchir périodiquement les données de configuration, on peut obtenir d'une manière simple une protection contre des erreurs provoquées par des rayonnements. En outre, il est possible de désactiver la mémoire lorsque le pavé n'est pas en cours de rafraîchissement, ou si le pavé n'est pas en service, économisant ainsi de l'énergie.

Bien qu'on ait décrit un certain nombre de modes de réalisation spécifiques, il sera clair pour l'homme de l'art qu'il y a diverses modifications qui pourraient être appliquées.

Par exemple, il sera clair pour l'homme de l'art que les divers transistors qui sont décrits comme étant des transistors NMOS pourraient être mis en oeuvre sous forme de transistors PMOS, et vice versa. Par exemple, dans le circuit de la figure 5A, le transistor 502 pourrait être un transistor NMOS couplé à la masse, plutôt qu'à VDD, et les transistors NMOS 524 et 526 pourraient être des transistors PMOS couplés à la tension d'alimentation VDD plutôt qu'à la masse. En outre, bien que les divers modes de réalisation aient été décrits en relation avec des transistors MOS, il sera clair pour l'homme de l'art qu'on pourrait utiliser d'autres technologies de transistors, comme la technologie bipolaire.

En outre, il sera clair pour l'homme de l'art que la tension de masse décrite ici peut être à 0 V, ou plus généralement à une tension d'alimentation V_{SS} quelconque, qui pourrait être différente de 0 V et que la tension de masse et la tension d'alimentation pourraient être permutées.

En outre, les fonctionnalités décrites en relation avec les divers modes de réalisation pourraient être combinées d'une manière quelconque dans des variantes de réalisation.

## Revendications

1. Dispositif logique reprogrammable (100) comprenant une pluralité de pavés élémentaires (102), chaque pavé (102) comprenant :
au moins un bloc logique (108) configurable par une ou plusieurs cellules de mémoire volatile (322) mémorisant des données de configuration ; et
une mémoire (116) comprenant :
une pluralité de cellules de mémoire non volatile (402) mémorisant des données de rafraîchissement, chaque cellule de mémoire non volatile (402) comprenant des premier et deuxième éléments à commutation de résistance (520, 522), chacun étant programmable pour avoir l'une d'une première et d'une deuxième valeur de résistance (Rmin, Rmax) représentative de la donnée de rafraîchissement ; et **caractérisé en ce que** la mémoire (116) comprend :
un circuit de lecture-écriture (408) adapté à rafraîchir périodiquement les données de configuration sur la base des données de rafraîchissement, dans lequel chacune d'une première et d'une deuxième des cellules de mémoire non volatile (402) est couplée à un premier et un deuxième noeud (508, 510) du circuit de lecture-écriture (408) , et le circuit de lecture-écriture (408) est adapté à rafraîchir périodiquement la donnée de configuration d'une première des cellules de mémoire volatile (322) sur la base de la donnée de rafraîchissement stockée par la première cellule de mémoire non volatile (402) , et à rafraîchir périodiquement la donnée de configuration d'une deuxième des cellules de mémoire volatile (322) sur la base de la donnée de rafraîchissement stockée par la deuxième cellule de mémoire non volatile (402).

2. Dispositif reprogrammable (100) selon la revendication 1,
dans lequel chacune desdites une ou plusieurs cellules de mémoire volatile (322) comprend une capacité (334) pour mémoriser un état de tension représentatif de la donnée de configuration.

3. Dispositif reprogrammable (100) selon la revendication 1 ou 2, dans lequel chacune des cellules de mémoire volatile (322) comprend un transistor de sélection (330), et chacun des premier et deuxième éléments à commutation de résistance (520, 522) est couplé en série avec un autre transistor de sélection (524, 526) .

4. Dispositif reprogrammable (100) selon l'une quelconque des revendications 1 à 3, dans lequel un bit de données de rafraîchissement mémorisé par chacune des cellules de mémoire non volatile (402) est déterminé par les résistances relatives des premier et deuxième éléments à commutation de résistance (520, 522).

5. Dispositif reprogrammable (100) selon l'une quelconque des revendications 1 à 4, dans lequel les données de configuration contrôlent un ou plusieurs des éléments suivants :
les valeurs de données se trouvant dans une table de correspondance (310) du bloc logique (108) ;
la sélection de lignes d'entrée (104) du bloc logique ; et
la sélection de lignes de sortie (106) du bloc logique.

6. Dispositif reprogrammable (100) selon l'une quelconque des revendications 1 à 5, dans lequel la mémoire (116) comprend en outre un module d'activation (410) pour activer sélectivement la mémoire (116).

7. Dispositif reprogrammable (100) selon l'une quelconque des revendications 1 à 6, dans lequel le circuit de lecture-écriture (408) comprend une bascule comprenant des premier et deuxième transistors (504, 506), dans lequel une première borne (508) du premier élément à commutation de résistance (520) de chacune de la pluralité de cellules de mémoire non volatile (402) est couplée au premier transistor (504), et une première borne (510) du deuxième élément à commutation de résistance (522) de chacune de la pluralité de cellules de mémoire non volatile (402) est couplée au deuxième transistor (506).

8. Dispositif reprogrammable (100) selon la revendication 7, comprenant en outre un circuit de commande (204), dans lequel le premier transistor (504) est couplé entre un premier noeud de mémorisation (802) et une première tension d'alimentation (GND, V_{DD}), le deuxième transistor (506) est couplé entre un deuxième noeud de mémorisation (806) et la première tension d'alimentation (GND, V_{DD}), une borne de commande du premier transistor (504) étant couplée au deuxième noeud de mémorisation (806), et une borne de commande du deuxième transistor (506) étant couplée au premier noeud de mémorisation (802), et dans lequel le circuit de commande est adapté à appliquer, pendant une phase de programmation du premier élément à commutation de résistance (520) , une deuxième tension d'alimentation au deuxième noeud de mémorisation pour activer le premier transistor (504), puis à appliquer la deuxième tension d'alimentation au premier noeud de mémorisation pour générer un premier courant d'écriture (I_{A}) dans le premier transistor (504) et le premier élément à commutation de résistance (520) .

9. Dispositif reprogrammable (100) selon la revendication 8, dans lequel le circuit de commande est en outre adapté à isoler le deuxième noeud de mémorisation (806) de la deuxième tension d'alimentation, puis à appliquer, pendant une phase de programmation du deuxième élément à commutation de résistance (522), la deuxième tension d'alimentation au deuxième noeud de mémorisation (806) pour générer un deuxième courant d'écriture (I_{B}) dans le deuxième transistor (506) et le deuxième élément à commutation de résistance (522).

10. Dispositif reprogrammable (100) selon la revendication 8 ou 9, dans lequel la mémoire comprend en outre un troisième transistor (804) couplant le premier noeud de mémorisation (802) à la deuxième tension d'alimentation et un quatrième transistor (808) couplant le deuxième noeud de mémorisation (806) à la deuxième tension d'alimentation.

11. Dispositif reprogrammable (100) selon la revendication 10, dans lequel le troisième transistor (804) est adapté à avoir une tension de seuil inférieure à celle du premier transistor (504) et le quatrième transistor (808) est adapté à avoir une tension de seuil inférieure à celle du deuxième transistor (506).

12. Dispositif reprogrammable (100) selon l'une quelconque des revendications 8 à 11, dans lequel le circuit de lecture-écriture (408) comprend en outre un cinquième transistor (512) couplé entre les premier et deuxième noeuds de mémorisation (508, 510).

13. Dispositif reprogrammable (100) selon l'une quelconque des revendications 1 à 12, comprenant en outre :
une pluralité desdits pavés élémentaires (102) ; et
un contrôleur (204) adapté à contrôler au moins l'activation de la mémoire de chacun des pavés élémentaires et le rafraîchissement des données de configuration de chacun des pavés.

14. Dispositif reprogrammable (100) selon l'une quelconque des revendications 1 à 13, dans lequel les premier et deuxième éléments à commutation de résistance (520, 522) sont d'un des types suivants :
des éléments à commutation assistée thermiquement (TAS) ;
des éléments résistifs à oxyde ;
des éléments à pontage conducteur ;
des éléments à changement de phase ;
des éléments à métallisation programmable ;
des éléments à transfert de spin ; et
des éléments à commutation magnétique induite par champ (FIMS).

15. Procédé pour rafraîchir un dispositif reprogrammable (100) comprenant une pluralité de pavés élémentaires (102), chaque pavé comprenant au moins un bloc logique (108) comprenant une ou plusieurs entrées couplées à une ou plusieurs cellules de mémoire volatile (322) mémorisant des données de configuration, **caractérisé en ce que** le procédé comprend l'étape suivante :
rafraîchir périodiquement les données de configuration sur la base de données de rafraîchissement mémorisées dans des cellules de mémoire non volatile (402) d'une mémoire (116), chaque cellule de mémoire non volatile (402) comprenant des premier et deuxième éléments à commutation de résistance (520, 522), chacun étant programmable pour avoir l'une d'une première et d'une deuxième valeur de résistance (Rmin, Rmax), dans lequel chacune d'une première et d'une deuxième des cellules de mémoire non volatile (402) est couplée à un premier et un deuxième noeud (508, 510) d'un circuit de lecture-écriture (408) , et le circuit de lecture-écriture (408) est adapté à rafraîchir périodiquement la donnée de configuration d'une première des cellules de mémoire volatile (322) sur la base de la donnée de rafraîchissement stockée par la première cellule de mémoire non volatile (402), et à rafraîchir périodiquement la donnée de configuration d'une deuxième des cellules de mémoire volatile (322) sur la base de la donnée de rafraîchissement stockée par la deuxième cellule de mémoire non volatile (402).

## Patentansprüche

1. Reprogrammierbare logische Vorrichtung (100), die eine Vielzahl von Kacheln (102) aufweist, wobei jede Kachel (102) Folgendes aufweist:
wenigstens einen Logikblock (108), der durch eine oder mehrere flüchtige Speicherzellen (322) konfigurierbar ist, die Konfigurationsdaten speichern; sowie
einen Speicher (116) aufweisend:
eine Vielzahl von nicht-flüchtigen Speicherzellen (402), die Auffrischungsdaten speichern, wobei jede nicht-flüchtige Speicherzelle (402) erste und zweite Widerstandsschaltelemente (520, 522) aufweist, die jeweils so programmierbar sind, dass sie einen aus ersten und zweiten Widerstandswerten (Rmin, Rmax) aufweisen, die für die Auffrischungsdaten repräsentativ sind; und **dadurch gekennzeichnet, dass** der Speicher (116) Folgendes aufweist:
eine Lese-Schreib-Schaltung (408), die geeignet ist zum periodischen Auffrischen der Konfigurationsdaten auf der Grundlage der Auffrischungsdaten, wobei jede aus einer ersten und einer zweiten der nicht-flüchtigen Speicherzellen (402) mit einem ersten und einem zweiten Knoten (508, 510) der Lese-Schreib-Schaltung (408) gekoppelt ist, und die Lese-Schreib-Schaltung (408) geeignet ist zum periodischen Auffrischen der Konfigurationsdaten einer ersten der flüchtigen Speicherzellen (322) basierend auf den Auffrischungsdaten, die von der ersten nicht-flüchtigen Speicherzelle (402) gespeichert werden, und zum periodischen Auffrischen der Konfigurationsdaten einer zweiten der flüchtigen Speicherzellen (322) basierend auf den Auffrischungsdaten, die von der zweiten nicht-flüchtigen Speicherzelle (402) gespeichert werden.

2. Reprogrammierbare Vorrichtung (100) nach Anspruch 1, wobei die eine oder die mehreren flüchtigen Speicherzellen (322) jeweils eine Kapazität (334) zum Speichern eines für die Konfigurationsdaten repräsentativen Spannungszustands aufweisen.

3. Reprogrammierbare Vorrichtung (100) nach Anspruch 1 oder 2, wobei jede der flüchtigen Speicherzellen (322) einen Auswahltransistor (330) aufweist, und jedes der ersten und zweiten Widerstandsschaltelemente (520, 522) in Reihe mit einem weiteren Auswahltransistor (524, 526) gekoppelt ist.

4. Reprogrammierbare Vorrichtung (100) nach einem der Ansprüche 1 bis 3, wobei ein Auffrischungsdatenbit, das von jeder der nicht-flüchtigen Speicherzellen (402) gespeichert wird, durch die relativen Widerstände der ersten und zweiten Widerstandsschaltelemente (520, 522) bestimmt wird.

5. Reprogrammierbare Vorrichtung (100) nach einem der Ansprüche 1 bis 4, wobei die Konfigurationsdaten eines oder mehrere der folgenden steuern:
die Datenwerte in einer Lookup-Tabelle (310) des Logikblocks (108) die Auswahl von Eingangsleitungen (104) des Logikblocks; und
die Auswahl von Ausgangsleitungen (106) des Logikblocks.

6. Reprogrammierbare Vorrichtung (100) nach einem der Ansprüche 1 bis 5, wobei der Speicher (116) ferner ein Aktivierungsmodul (410) zum selektiven Aktivieren des Speichers (116) aufweist.

7. Reprogrammierbare Vorrichtung (100) nach einem der Ansprüche 1 bis 6, wobei die Lese-Schreib-Schaltung (408) ein Auffangregister mit einem ersten und einem zweiten Transistor (504, 506) aufweist, wobei ein erster Anschluss (508) des ersten Widerstandsschaltelements (520) von jeder der Vielzahl von nicht-flüchtigen Speicherzellen (402) mit dem ersten Transistor (504) gekoppelt ist, und ein erster Anschluss (510) des zweiten Widerstandsschaltelements (522) jeder der Vielzahl von nicht-flüchtigen Speicherzellen (402) mit dem zweiten Transistor (506) gekoppelt ist.

8. Reprogrammierbare Vorrichtung (100) nach Anspruch 7, ferner aufweisend eine Steuerschaltung (204), wobei der erste Transistor (504) zwischen einen ersten Speicherknoten (802) und eine erste Versorgungsspannung (GND, V_{DD}) gekoppelt ist, der zweite Transistor (506) zwischen einen zweiten Speicherknoten (806) und die erste Versorgungsspannung (GND, V_{DD}) gekoppelt ist, ein Steueranschluss des ersten Transistors (504) mit dem zweiten Speicherknoten (806) gekoppelt ist, und ein Steueranschluss des zweiten Transistors (506) mit dem ersten Speicherknoten (802) gekoppelt ist, und wobei die Steuerschaltung geeignet ist zum Anlegen, während einer Programmierphase des ersten Widerstandsschaltelements (520), einer zweiten Versorgungsspannung an den zweiten Speicherknoten, um den ersten Transistor (504) zu aktivieren, und dann zum Anlegen der zweiten Versorgungsspannung an den ersten Speicherknoten, um einen ersten Schreibstrom (I_{A}) durch den ersten Transistor (504) und das erste Widerstandsschaltelement (520) zu erzeugen.

9. Reprogrammierbare Vorrichtung (100) nach Anspruch 8, wobei die Steuerschaltung ferner geeignet ist zum Isolieren des zweiten Speicherknotens (806) gegenüber der zweiten Versorgungsspannung und dann zum Anlegen, während einer Programmierphase des zweiten Widerstandsschaltelements (522), der zweite Versorgungsspannung an den zweiten Speicherknoten (806), um einen zweiten Schreibstrom (I_{B}) durch den zweiten Transistor (506) und das zweite Widerstandsschaltelement (522) zu erzeugen.

10. Reprogrammierbare Vorrichtung (100) nach Anspruch 8 oder 9, wobei der Speicher ferner einen dritten Transistor (804) aufweist, der den ersten Speicherknoten (802) mit der zweiten Versorgungsspannung koppelt, und einen vierten Transistor (808), der den zweiten Speicherknoten (806) mit der zweiten Versorgungsspannung koppelt.

11. Reprogrammierbare Vorrichtung (100) nach Anspruch 10, wobei der dritte Transistor (804) so angepasst ist, dass er eine niedrigere Schwellenspannung als der erste Transistor (504) aufweist und der vierte Transistor (808) so angepasst ist, dass er eine niedrigere Schwellenspannung als der zweite Transistor (506) aufweist.

12. Reprogrammierbare Vorrichtung (100) nach einem der Ansprüche 8 bis 11, wobei die Schreib-Lese-Schaltung (408) ferner einen fünften Transistor (512) aufweist, der zwischen den ersten und zweiten Speicherknoten (508, 510) gekoppelt ist.

13. Reprogrammierbare Vorrichtung (100) nach einem der Ansprüche 1 bis 12, wobei die Vorrichtung weiterhin Folgendes aufweist:
eine Vielzahl der Kacheln (102); und
eine Steuereinheit (204), die geeignet ist zum Steuern wenigstens der Aktivierung des Speichers jeder der Kacheln und des Auffrischens der Konfigurationsdaten von jeder der Kacheln.

14. Reprogrammierbare Vorrichtung (100) nach einem der Ansprüche 1 bis 13, wobei die ersten und zweiten Widerstandsschaltelemente (520, 522) eines der Folgenden sind:
thermisch unterstützte Schaltelemente (TAS);
Oxidwiderstandselemente;
leitende Überbrückungselemente;
Phasenwechsel-Elemente;
programmierbare Metallisierungselemente;
Spin-Transfer-Drehmoment-Elemente; und
feldinduzierte magnetische Schaltelemente (FIMS).

15. Verfahren zum Auffrischen einer reprogrammierbaren Vorrichtung (100), die eine Vielzahl von Kacheln (102) aufweist, wobei jede Kachel wenigstens einen Logikblock (108) aufweist, der einen oder mehrere Eingänge aufweist, die mit einer oder mehreren flüchtigen Speicherzelle(n) (322) gekoppelt ist/sind, die Konfigurationsdaten speichern, **dadurch gekennzeichnet, dass** das Verfahren Folgendes aufweist:
periodisches Auffrischen der Konfigurationsdaten auf der Grundlage von Auffrischungsdaten, die in nichtflüchtigen Speicherzellen (402) eines Speichers (116) gespeichert sind, wobei jede nichtflüchtige Speicherzelle (402) erste und zweite Widerstandsschaltelemente (520, 522) aufweist, die jeweils so programmierbar sind, dass sie einen aus ersten und zweiten Widerstandswerten (Rmin, Rmax) besitzen, wobei jede aus einer ersten und einer zweiten der nichtflüchtigen Speicherzellen (402) mit einem ersten und einem zweiten Knoten (508, 510) einer Lese-Schreib-Schaltung (408) gekoppelt ist, und die Lese-Schreib-Schaltung (408) geeignet ist zum periodischen Auffrischen der Konfigurationsdaten einer ersten der flüchtigen Speicherzellen (322) basierend auf den Auffrischungsdaten, die von der ersten nicht-flüchtigen Speicherzelle (402) gespeichert werden, und zum periodischen Auffrischen der Konfigurationsdaten einer zweiten der flüchtigen Speicherzellen (322) basierend auf den Auffrischungsdaten, die von der zweiten nicht-flüchtigen Speicherzelle (402) gespeichert werden.

## Claims

1. A reprogrammable logic device (100) comprising a plurality of tiles (102), each tile (102) comprising:
at least one logic block (108) configurable by one or more volatile memory cells (322) storing configuration data; and
a memory (116) comprising:
a plurality of non-volatile memory cells (402) storing refresh data, each non-volatile memory cell (402) comprising first and second resistance switching elements (520, 522) each programmable to have one of first and second resistance values (Rmin, Rmax) representative of said refresh data; and **characterised in that** the memory (116) comprises:
read-write circuitry (408) adapted to periodically refresh said configuration data based on said refresh data, wherein each of a first and a second of the non-volatile memory cells (402) is coupled to a first and a second node (508, 510) of the read-write circuitry (408), and the read-write circuitry (408) is adapted to periodically refresh the configuration data of a first of the volatile memory cells (322) based on the refresh data stored by the first non-volatile memory cell (402), and to periodically refresh the configuration data of a second of the volatile memory cells (322) based on the refresh data stored by the second non-volatile memory cell (402).

2. The reprogrammable device (100) of claim 1, wherein said one or more volatile memory cells (322) each comprises a capacitance (334) for storing a voltage state representative of said configuration data.

3. The reprogrammable device (100) of claim 1 or 2, wherein each of said volatile memory cells (322) comprises a selection transistor (330), and each of said first and second resistance switching elements (520, 522) is coupled in series with a further selection transistor (524, 526).

4. The reprogrammable device (100) of any of claims 1 to 3, wherein a refresh data bit stored by each of said non-volatile memory cells (402) is determined by the relative resistances of the first and second resistance switching elements (520, 522).

5. The reprogrammable device (100) of any of claims 1 to 4, wherein said configuration data controls one or more of:
the data values in a lookup table (310) of said logic block (108);
the selection of input lines (104) of said logic block; and
the selection of output lines (106) of said logic block.

6. The reprogrammable device (100) of any of claims 1 to 5, wherein said memory (116) further comprises an activation module (410) for selectively activating said memory (116).

7. The reprogrammable device (100) of any of claims 1 to 6, wherein said read-write circuitry (408) comprises a latch comprising first and second transistors (504, 506), wherein a first terminal (508) of the first resistance switching element (520) of each of said plurality of non-volatile memory cells (402) is coupled to said first transistor (504), and a first terminal (510) of the second resistance switching element (522) of each of said plurality of non-volatile memory cells (402) is coupled to said second transistor (506).

8. The reprogrammable device (100) of claim 7, further comprising a control circuit (204), wherein said first transistor (504) is coupled between a first storage node (802) and a first supply voltage (GND, V_{DD}), said second transistor (506) is coupled between a second storage node (806) and said first supply voltage (GND, V_{DD}), a control terminal of said first transistor (504) being coupled to said second storage node (806), and a control terminal of said second transistor (506) being coupled to said first storage node (802), and wherein said control circuit is adapted to apply, during a programming phase of the first resistance switching element (520), a second supply voltage to said second storage node to activate said first transistor (504), and then to apply said second supply voltage to said first storage node to generate a first write current (I_{A}) through said first transistor (504) and said first resistance switching element (520) .

9. The reprogrammable device (100) of claim 8, wherein said control circuit is further adapted to isolate said second storage node (806) from said second supply voltage, and then to apply, during a programming phase of the second resistance switching element (522), said second supply voltage to said second storage node (806) to generate a second write current (I_{B}) through said second transistor (506) and said second resistance switching element (522).

10. The reprogrammable device (100) of claim 8 or 9, wherein said memory further comprises a third transistor (804) coupling said first storage node (802) to said second supply voltage and a fourth transistor (808) coupling said second storage node (806) to said second supply voltage.

11. The reprogrammable device (100) of claim 10, wherein said third transistor (804) is adapted to have a lower threshold voltage than said first transistor (504) and said fourth transistor (808) is adapted to have a lower threshold voltage than said second transistor (506).

12. The reprogrammable device (100) of any of claims 8 to 11, wherein the read-write circuitry (408) further comprises a fifth transistor (512) coupled between said first and second storage nodes (508, 510).

13. The reprogrammable device (100) of any of claims 1 to 12, further comprising:
a plurality of said tiles (102); and
a controller (204) adapted to control at least the activation of said memory of each of said tiles and the refreshing of the configuration data of each of said tiles.

14. The reprogrammable device (100) of any of claims 1 to 13, wherein said first and second resistance switching elements (520, 522) are one of:
thermally assisted switching (TAS) elements;
oxide resistive elements;
conductive bridging elements;
phase change elements;
programmable metallization elements;
spin transfer torque elements; and
field-induced magnetic switching (FIMS) elements.

15. A method of refreshing a reprogrammable device (100) comprising a plurality of tiles (102), each tile comprising at least one logic block (108) comprising one or more inputs coupled to one or more volatile memory cells (322) storing configuration data, **characterised in that** the method comprises:
periodically refreshing said configuration data based on refresh data stored in non-volatile memory cells (402) of a memory (116), wherein each non-volatile memory cell (402) comprises first and second resistance switching elements (520, 522) each programmable to have one of first and second resistance values (Rmin, Rmax), wherein each of a first and a second of the non-volatile memory cells (402) is coupled to a first and a second node (508, 510) of read-write circuitry (408), and the read-write circuitry (408) is adapted to periodically refresh the configuration data of a first of the volatile memory cells (322) based on the refresh data stored by the first non-volatile memory cell (402), and to periodically refresh the configuration data of a second of the volatile memory cells (322) based on the refresh data stored by the second non-volatile memory cell (402).
